# EUROPÄISCHE PATENTSCHRIFT

(11) **EP 0 800 592 B1**
(45) Veröffentlichungstag und Bekanntmachung des Hinweises auf die Patenterteilung: **26.08.1998**
(21) Anmeldenummer: 95941581.1
(22) Anmeldetag: 13.12.1995
(51) Int. Cl.: C30B 25/02, C30B 23/02, C23C 16/32, C23C 14/06

(54) **VERFAHREN ZUM HERSTELLEN VON MIT BOR DOTIERTEM, EINKRISTALLINEM SILICIUMCARBID**
METHOD OF PRODUCING BORON-DOPED MONOCRYSTALLINE SILICON CARBIDE
PROCEDE DE PRODUCTION DE CARBURE DE SILICIUM MONOCRISTALLIN DOPE AVEC DU BORE

(30) Priorität: 27.12.1994 DE 4446866; 13.02.1995 DE 19504669
(43) Veröffentlichungstag der Anmeldung: 15.10.1997
(73) Patentinhaber: SIEMENS AKTIENGESELLSCHAFT, 80333 München (DE)
(72) Erfinder: STEIN, René, D-91341 Röttenbach (DE); RUPP, Roland, D-91207 Lauf (DE)
(86) Internationale Anmeldenummer: DE9501787
(87) Internationale Veröffentlichungsnummer: WO9620298

(56) Entgegenhaltungen:
- EP-A- 0 554 047
- US-A- 4 912 064
- PATENT ABSTRACTS OF JAPAN vol. 013, no. 243 (E-768), 7.Juni 1989 & JP,A,01 045115 (MEIDENSHA ELECTRIC MFG CO LTD), 17.Februar 1989,

## Beschreibung

Die Erfindung betrifft ein Verfahren zum Herstellen von mit Bor (B) dotiertem, einkristallinem Siliciumcarbid.

Bor ist neben Aluminium der wichtigste Dotierstoff zum p-Dotieren von einkristallinem SiC-Halbleitermaterial.

Aus *Applied Physics Letters, Vol. 42, No. 5, 1 March 1983, Seiten 460-462* ist ein Verfahren zum Herstellen einer mit Bor dotierten Schicht aus einkristallinem Siliciumcarbid (SiC) des 3C-Polytyps (β-SiC) durch chemische Gasphasenabscheidung (Chemical Vapour Deposition = CVD) auf einem einkristallinen Siliciumsubstrat bei einer Temperatur von 1400°C bekannt. Bei diesem bekannten Verfahren werden als Trägergas Wasserstoff (H₂), als Arbeitsgas zum Zuführen von Silicium (Si) Silan (SiH₄) mit einem Molanteil von 0,04 % in dem Trägergas H₂ und als Arbeitsgas zum Zuführen von Kohlenstoff (C) Propan (C₃H₈) mit einem Molanteil von 0,02 % in H₂ verwendet. Zum Dotieren wird dem Gasgemisch aus dem Trägergas und den beiden Arbeitsgasen das Dotiergas Diboran (B₂H₆) mit einem Anteil von 100 ppm in H₂ zugesetzt. Die abgeschiedene β-SiC-Schicht weist eine Ladungsträgerkonzentration von Löchern (p-Leitungstyp) von 5,6 10¹⁴ bis 1,6 10¹⁵ cm⁻³ auf.

Bei einem weiteren, aus *Journal of the Electrochemical Society, Vol. 133, No. 11, November 1986, Seiten 2350-2357* bekannten Verfahren wird eine mit Bor dotierte β-SiC-Schicht durch CVD-Epitaxie bei einer Temperatur von 1360°C mit Silan (SiH₄) und Ethen (C₂H₄) als Arbeitsgasen, Wasserstoff (H₂) als Trägergas und Diboran (B₂H₆) als Dotiergas hergestellt. Bei einer mit diesem bekannten Verfahren hergestellten SiC-Schicht ist nur ein kleiner Teil (0,2 %) der in das SiC eingebrachten Boratome elektrisch aktiv. Um eine hohe Ladungsträgerkonzentration des p-Leitungstyps zu erreichen, muß deshalb die Atomkonzentration des Bor im SiC so hoch gewählt werden, daß die Oberflächenqualität der aufwachsenden SiC-Schicht stark herabgesetzt wird.

Aus der US-A-4,923,716 ist ein weiterer CVD-Prozeß zum Herstellen von bordotiertem β-SiC mit Diboran als Dotiergas bekannt.

Es sind ferner Sublimationsprozesse zum Herstellen von einkristallinem SiC bekannt, bei denen ein SiC-Volumenkristall (bulk crystal) aus sublimiertem SiC in der Gasphase (hauptsächlich Si, Si₂C, SiC₂) auf einer Gefäßwand (Lely-Verfahren) oder auf einem Keimkristall (modifiziertes Lely-Verfahren) aufgewachsen wird.

Es sind ferner plasmaunterstützte CVD-Prozesse zum Abscheiden einer bordotierten amorphen Silicium-Kohlenstoff-Verbindung a-Si₁₋ₓCₓ:H mit Wasserstoffeinschlüssen auf einem Substrat bekannt. Zum Dotieren der a-Si₁₋ₓCₓ:H-Schicht mit Bor wird einem Wasserstoffgas und Silan enthaltenden Arbeitsgas eine organische Borverbindung mit einem ungesättigten Kohlenwasserstoffrest oder Trimethylbor oder Triethylbor zugesetzt. Die Abscheidetemperaturen am Substrat liegen zwischen 150°C und maximal 300°C. Über die Bordotierung wird der optische Bandabstand der a-Si₁₋ₓCₓ:H-Schicht eingestellt. Solche a-S₁₋ₓCₓ:H-Schichten werden als p-Schicht in einer p-i-n-Solarzelle auf Basis von amorphem Silicium eingesetzt. Der Anteil an Silicium in diesen bekannten a-S₁₋ₓCₓ:H-Schichten ist deutlich größer als der Anteil an Kohlenstoff (*EP-A-0 573 033* oder *Patent Abstracts of Japan, C-711, April 19, 1990, Vol. 14, No. 192* oder *Physica B, Heft 170 (1991), Seiten 574 - 576* oder *Journal of Non-Crystalline Solids, Heft 137 + 138 (1991), Seiten 701 - 704* oder *Materials Research Society Symposium Proceedings, Vol. 118 (1988), S. 557 - 559* oder *Philosophical Magazine B, 1991, Vol. 64, No. 1, Seiten* *101 - 111*). Mit diesen bekannten Verfahren können keine einkristallinen SiC-Schichten hergestellt werden.

Der Erfindung liegt nun die Aufgabe zugrunde, ein Verfahren zum Herstellen von mit Bor dotiertem, einkristallinem Siliciumcarbid anzugeben, bei dem die in das Siliciumcarbid-Kristallgitter eingebauten Boratome einen hohen Aktivierungsgrad aufweisen.

Diese Aufgabe wird gemäß der Erfindung gelöst mit den Merkmalen des Anspruchs 1 oder mit den Merkmalen des Anspruchs 5.

In einem CVD-Prozeß zum Herstellen von einkristallinem SiC, das mit Bor p-dotiert ist, gemäß Anspruch 1 werden wenigstens ein Arbeitsgas zum Zuführen von Silicium (Si) und Kohlenstoff (C) und wenigstens eine organische Borverbindung zum Dotieren verwendet. Die Moleküle der wenigstens einen organischen Borverbindung enthalten jeweils wenigstens ein Boratom, das chemisch mit wenigstens einem Kohlenstoffatom gebunden ist. In der mit diesem CVD-Prozeß auf einem Substrat aufgewachsenen, einkristallinen SiC-Schicht sind deutlich mehr Boratome elektrisch aktiviert als bei den mit bekannten Verfahren bordotierten SiC-Schichten. Das Verhältnis von Ladungsträgerkonzentration der Löcher (p-Leitung) zur chemischen Atomkonzentration der Boratome im Kristallgitter der SiC-Schicht ist somit entsprechend höher und kann sogar nahezu 1 betragen.

In einem Sublimationsprozeß gemäß Anspruch 5 wird festes Siliciumcarbid (SiC) wenigstens teilweise sublimiert und aus dem sublimierten Siliciumcarbid in der Gasphase das einkristalline SiC gebildet. Es wird wenigstens eine organische Borverbindung zum Dotieren des auskristallisierenden SiC-Einkristalls verwendet. Die Moleküle der wenigstens einen organischen Borverbindung enthalten jeweils wenigstens ein Boratom, das chemisch mit wenigstens einem Kohlenstoffatom gebunden ist.

Boratome (B-Atome) können als Störstellenatome auf Silicium(Si)-Gitterplätzen, Kohlenstoff(C)-Gitterplätzen oder auch auf Zwischengitterplatzen in das SiC-Kristallgitter eingebaut werden. Ein Boratom auf einem Si-Gitterplatz ist elektrisch aktiv und bildet ein Akzeptor-Energieniveau von zwischen etwa 250 meV und 300 meV im 4H-Polytyp des SiC und zwischen etwa 300 meV und etwa 350 meV im 6H-Polytyp von SiC. Da dieses Akzeptorniveau jedoch vergleichsweise tief ist, sind bei Raumtemperatur nur maximal etwa 1 % der Boratome im SiC-Kristall thermisch ionisiert. Die elektrische Aktivität von Boratomen auf C-Gitterplätzen ist nicht vollständig geklärt. Möglicherweise bildet das Bor auf diesen C-Gitterplätzen ein tiefes Energieniveau, dessen Beitrag zur Leitfähigkeit (Donator oder Akzeptor) noch nicht ermittelt werden konnte. Dagegen kann davon ausgegangen werden, daß Boratome auf Zwischengitterplätzen im SiC-Kristall im wesentlichen nicht elektrisch aktiv sind.

Die Erfindung beruht auf der Erkenntnis, daß bei Verwendung von organischen Borverbindungen als Dotierstoffen das Bor bereits in der Gasphase in den Molekülen der Borverbindung in einer chemischen Bindung zu wenigstens einem benachbarten C-Atom steht. Damit wird der Einbau der Boratome auf Si-Gitterplätze im SiC-Kristallgitter deutlich gefördert. Auf den Si-Gitterplätzen eingebaute Boratome weisen aber gerade die bereits erwähnten Störstellen-Energieniveaus auf, die als Akzeptorniveaus zur p-Leitung beitragen. Damit erklärt sich der hohe Aktivierungsgrad der mit dem Verfahren gemäß der Erfindung in die SiC-Kristallschicht eingebrachten Bor-Störstellen.

Mit dem Verfahren gemäß der Erfindung kann insbesondere α-SiC, beispielsweise des 4H- oder 6H-Polytyps, mit einer p-Ladungsträgerkonzentration von vorzugsweise etwa 10¹⁵ cm⁻³ bis etwa 5·10¹⁹ cm⁻³ hergestellt werden.

Vorteilhafte Ausgestaltungen und Weiterbildungen des Verfahrens ergeben sich aus den vom Anspruch 1 und Anspruch 5 jeweils abhängigen Ansprüchen.

In einer Ausführungsform wird eine organische Borverbindung verwendet, deren Moleküle wenigstens einen verzweigten oder unverzweigten kettenförmigen (aliphatischen) Kohlenwasserstoffrest aufweisen, beispielsweise einen Alkylrest oder auch einen ungesättigten Kohlenwasserstoffrest mit Doppel- und/ oder Dreifachbindungen zwischen wenigstens einem Teil seiner Kohlenstoffatome.

In einer weiteren Ausführungsform enthält die organische Borverbindung wenigstens einen ringförmigen Kohlenwasserstoffrest, beispielsweise einen Cycloalkylrest oder einen aromatischen Kohlenwasserstoffrest.

In einer besonders vorteilhaften Ausführungsform wird in den Molekülen der organischen Borverbindung wenigstens ein Boratom von drei Kohlenstoffatomen in einer im allgemeinen tetraedrischen Bindung umgeben. Beispiele für solche Dotiersubstanzen sind Bortrialkyle wie Bortrimethyl, Bortriethyl, Bortripropyl, Bortributyl oder Bortripentyl in allen Isomeren oder auch aromatische Verbindungen wie Bortriphenyl. Die Bindung des Boratoms entspricht in dieser Ausführungsform bereits in der Gasphase der späteren Bindung auf einem Si-Gitterplatz im SiC-Kristall. Der Einbau von Boratomen auf Si-Gitterplätzen wird dadurch besonders gefördert.

Die Wasserstoffatome in den Kohlenwasserstoffresten der organischen Borverbindung können auch wenigstens teilweise substituiert sein, insbesondere durch Halogenatome.

Schließlich können auch organische Borverbindungen mit mehreren Boratomen in ihren Molekülen verwendet werden, insbesondere dimere oder trimere Borverbindungen, bei denen zwei bzw. drei Boratome aneinander chemisch gebunden sind. Vorzugsweise ist dann jedes Boratom an wenigstens ein benachbartes Kohlenstoffatom gebunden.

Die organische Borverbindung wird vorzugsweise mit einem Trägergas zum sich bildenden einkristallinen SiC geführt. Bei flüssigen Borverbindungen wie beispielsweise den bereits genannten Bortriethyl, Bortripropyl und Bortributyl kann ein sogenanntes Bubbling-Verfahren verwendet werden. Beim Bubbling-Verfahren wird die flüssige Borverbindung in ein Gefäß (Kryostaten) gefüllt und das Trägergas wird durch die Flüssigkeit geleitet und dabei mit Bor angereichert. Das mit Bor angereicherte Trägergas wird zum Zuführen von Bor zum aufwachsenden SiC-Einkristall verwendet. Gegebenenfalls kann die Borkonzentration in diesem mit der organischen Borverbindung angereicherten Trägergas durch Verdünnen mit weiterem Trägergas noch verringert werden. Als Trägergas wird vorzugsweise Wasserstoff (H₂) verwendet. Es kann aber auch ein Edelgas wie beispielsweise Argon (Ar) oder ein Gemisch aus einem Edelgas und Wasserstoff als Trägergas verwendet werden.

Der Dampfdruck der flüssigen Borverbindung wird vorzugsweise durch Einstellen der Temperatur auf einen vorgegebenen Wert eingestellt. Typischerweise wird die Temperatur in der flüssigen Borverbindung zwischen etwa -50°C und etwa +30°C gewählt. Über den Dampfdruck der flüssigen organischen Borverbindung kann die Dotierstoffkonzentration des Bor in dem wachsenden SiC-Einkristall eingestellt werden.

Auch über die Durchflußrate des Trägergases beim Bubbling durch die flüssige organische Borverbindung kann die Dotierstoffkonzentration des Bor im SiC-Einkristall eingestellt werden. Typische Durchflußraten für das Bubbling-Trägergas liegen zwischen etwa 1 und 100 ml/min. Die Durchflußrate des Trägergases kann beispielsweise mit Hilfe eines Mass-flow-Controllers sehr genau eingestellt werden.

Bei gasförmigen organischen Borverbindungen wird die Borverbindung direkt oder mit einem Trägergas verdünnt zum wachsenden SiC-Einkristall geführt.

Als Arbeitsgase ("precursor", Prozeßgase) für den CVD-Prozeß können prinzipiell alle zum Zuführen von Si und C in der Gasphase geeigneten Gase verwendet werden. In einer vorteilhaften Ausführungsform wird ein Arbeitsgasgemisch aus wenigstens einem siliciumhaltigen, aber nicht kohlenstoffhaltigen Arbeitsgas wie beispielsweise Silan oder Disilan und wenigstens einem kohlenstoffhaltigen, aber nicht siliciumhaltigen Arbeitsgas wie beispielsweise einem Kohlenwasserstoffgas wie Methan, Propan oder Acethylen (Ethin) verwendet. Das Verhältnis C/Si von Kohlenstoff zu Silicium in der Gasphase kann dadurch variabel eingestellt werden. Bevorzugte Arbeitsgase in dieser Ausführungsform sind Silan (SiH₄) zum Bereitstellen von Silicium (Si) und Propan (C₃H₈) zum Bereitstellen von Kohlenstoff (C) in der Gasphase. Es kann aber auch ein sowohl silicium- als auch kohlenstoffhaltiges Arbeitsgas verwendet werden, beispielsweise die Substanz 1,3-Di-methyl-3-Methylsilamethylen-disilacyclo-butan oder auch Methylsilan.

In einer besonders vorteilhaften Ausführungsform wird ein Überschuß von Kohlenstoff in den Arbeitsgasen eingestellt. Das Verhältnis C/Si liegt dann insbesondere über 1 und insbesondere unter etwa 10 und vorzugsweise bei etwa 4. Durch den Kohlenstoffüberschuß in dem Arbeitsgasgemisch wird die Leerstellenkonzentration von Si-Gitterplätzen erhöht. Der Einbau von Boratomen auf Si-Gitterplätzen wird dadurch zusätzlich begünstigt.

Im allgemeinen wird beim CVD-Prozeß das Arbeitsgas bzw. das Arbeitsgasgemisch mit einem Trägergas verdünnt, typischerweise in einem Verhältnis von zwischen etwa 1:35 bis etwa 1:100. Als Trägergas für das wenigstens eine Arbeitsgas wird vorzugsweise Wasserstoff (H₂) verwendet. Das Verhältnis von Silan zu Wasserstoff kann in einer besonderen Ausführungsform zwischen etwa 2·10⁻⁵ und etwa 5·10⁻⁵ eingestellt werden. Es kann aber auch ein Edelgas wie beispielsweise Argon oder ein Gemisch aus Wasserstoff und einem Edelgas als Trägergas verwendet werden.

Das Gemisch aus Arbeitsgasen, organischer Borverbindung und Trägergasen wird im CVD-Prozeß nun vorzugsweise in einen Rezipienten geleitet oder dort zusammengeführt. In dem Rezipienten ist das wenigstens eine Substrat angeordnet. Auf einer Kristallisationsfläche des Substrats wird aus dem Gasgemisch durch chemische Abscheidung aus der Gasphase die bordotierte SiC-Schicht aufgewachsen. Für die Substrate können alle zum chemischen Abscheiden von SiC aus der Gasphase geeignete Materialien verwendet werden, beispielsweise Silicium oder Saphir und vorzugsweise SiC eines vorgegebenen Polytyps wie 4H oder 6H.

Die Wachstumstemperaturen an der Kristallisationsfläche des Substrats für den CVD-Prozeß werden im allgemeinen zwischen 1000°C und 2200°C und zum Herstellen von α-SiC insbesondere vom 4H- oder 6H-Polytyp im allgemeinen zwischen 1500°C und 2200°C, vorzugsweise zwischen 1500°C und 1700°C, eingestellt.

Der Anteil der organischen Borverbindung im Gas liegt vorzugsweise zwischen 10⁻⁸ und 10⁻⁶. Der Gesamtdruck der Gase in dem Rezipienten wird im allgemeinen zwischen etwa 100 Pa und etwa 2·10⁶ Pa und vorzugsweise zwischen etwa 2·10⁴ Pa und etwa 10⁵ Pa eingestellt. Bei Silan als Arbeitsgas beträgt das Verhältnis der organischen Borverbindung zu Silan vorzugsweise zwischen etwa 10⁻⁶ bis zu etwa 10⁻³.

Mit dem CVD-Verfahren gemäß der Erfindung konnten bordotierte, einkristalline SiC-Epitaxieschichten hergestellt werden, deren Boratomkonzentration im wesentlichen proportional (linear) zum Gaspartialdruck der organischen Borverbindung im Rezipienten am Substrat ansteigt von etwa 10¹⁶ cm⁻³ bei einem Partialdruck der organischen Borverbindung von 10⁻³ Pa (10⁻⁸ bar) bis etwa 10²⁰ cm⁻³ bei einem Partialdruck der organischen Borverbindung von etwa 1 Pa (10⁻⁵ bar). Die Boratomkonzentration kann somit über einen weiten Bereich exakt eingestellt werden.

Beim Sublimationsprozeß wird das Gemisch aus sublimiertem SiC in der Gasphase, organischer Borverbindung und gegebenenfalls Trägergasen vorzugsweise in einen Suszeptor aus temperaturbeständigem Material geleitet oder dort zusammengeführt. In dem Suszeptor kristallisiert der SiC-Einkristall mit Bordotierung. In einer vorteilhaften Ausführungsform des Sublimationsverfahrens wird der bordotierte SiC-Einkristall auf einer Kristallisationsfläche eines im Suszeptor angeordneten Keimkristalls aufgewachsen. Für den Keimkristall können alle zum Abscheiden von SiC über die Gasphase geeignete Materialien verwendet werden, vorzugsweise SiC eines vorgegebenen Polytyps wie 4H oder 6H oder 3C. Der Keimkristall wird vorzugsweise in dem Suszeptor angeordnet. Die Wachstumstemperaturen an der Kristallisationsfläche des Keimkristalls betragen beim Sublimationsprozeß im allgemeinen zwischen 1800°C und 2500°C, vorzugsweise zwischen 2100°C und 2300°C. Mit dem Sublimationsprozeß können prinzipiell alle Polytypen des SiC hergestellt werden.

## Patentansprüche

1. Verfahren zum Herstellen von mit Bor (B) dotiertem, einkristallinem Siliciumcarbid durch chemische Gasphasenabscheidung (CVD) auf einem Substrat,
bei dem
a) wenigstens ein Arbeitsgas zum Zuführen von Silicium (Si) und Kohlenstoff (C) sowie
b) wenigstens eine organische Borverbindung, in deren Molekülen wenigstens ein Kohlenstoffatom an wenigstens ein Boratom chemisch gebunden ist, zum Zuführen von Bor verwendet werden
und bei dem
c) die Wachstumstemperaturen am Substrat auf wenigstens 1000°C eingestellt werden.

2. Verfahren nach Anspruch 1, bei dem wenigstens eine Siliciumverbindung, die keinen Kohlenstoff (C) enthält, als Arbeitsgas zum Zuführen von Silicium (Si) und wenigstens eine Kohlenstoffverbindung, die kein Silicium enthält, als Arbeitsgas zum Zuführen von Kohlenstoff (C) verwendet werden.

3. Verfahren nach Anspruch 1 oder Anspruch 2, bei dem ein Überschuß von Kohlenstoff (C) in dem wenigstens einen Arbeitsgas eingestellt wird.

4. Verfahren nach einem der vorhergehenden Ansprüche, bei dem der Partialdruck der organischen Borverbindung am Substrat zwischen etwa 10⁻³ Pa und etwa 1 Pa eingestellt wird.

5. Verfahren zum Herstellen von mit Bor (B) dotiertem, einkristallinem Siliciumcarbid, bei dem
a) Siliciumcarbid in fester Form wenigstens teilweise sublimiert wird,
b) das einkristalline Siliciumcarbid aus dem sublimierten Siliciumcarbid in der Gasphase gebildet wird
und
c) wenigstens eine organische Borverbindung, in deren Molekülen wenigstens ein Kohlenstoffatom an wenigstens ein Boratom chemisch gebunden ist, zum Zuführen von Bor verwendet wird.

6. Verfahren nach Anspruch 5, bei dem das einkristalline Siliciumcarbid auf einem Keimkristall aufgewachsen wird.

7. Verfahren nach einem der vorhergehenden Ansprüche, bei dem die Moleküle der organischen Borverbindung wenigstens einen unverzweigten oder verzweigten kettenförmigen Kohlenwasserstoffrest enthalten.

8. Verfahren nach einem der vorhergehenden Ansprüche, bei dem die Moleküle der organischen Borverbindung wenigstens einen ringförmigen Kohlenwasserstoffrest enthalten.

9. Verfahren nach einem der vorhergehenden Ansprüche, bei dem die Moleküle der organischen Borverbindung jeweils wenigstens ein Halogenatom enthalten.

10. Verfahren nach einem der vorhergehenden Ansprüche, bei dem die Moleküle der organischen Borverbindung wenigstens zwei Boratome enthalten, die jeweils mit wenigstens einem Kohlenstoffatom chemisch gebunden sind.

11. Verfahren nach einem der vorhergehenden Ansprüche, bei dem wenigstens ein Trägergas durch die organische Borverbindung geleitet wird und das mit der organischen Borverbindung angereicherte Trägergas dem sich bildenden einkristallinen Siliciumcarbid zugeführt wird.

12. Verfahren nach Anspruch 11, bei dem als Trägergas Wasserstoff verwendet wird.

13. Verfahren nach Anspruch 11, bei dem als Trägergas wenigstens ein Edelgas verwendet wird.

14. Verfahren nach Anspruch 11, bei dem als Trägergas ein Gasgemisch aus Wasserstoff und wenigstens einem Edelgas verwendet wird.

15. Verfahren nach einem der Ansprüche 11 bis 14, bei dem die Dotierstoffkonzentration für das Bor in dem einkristallinen Siliciumcarbid durch Einstellen der Durchflußrate des Trägergases durch die organische Borverbindung eingestellt wird.

16. Verfahren nach einem der vorhergehenden Ansprüche, bei dem die Dotierstoffkonzentration für das Bor in dem einkristallinen Siliciumcarbid durch Einstellen der Temperatur der organischen Borverbindung gesteuert wird.

## Claims

1. Process for the preparation of monocrystalline silicon carbide doped with boron (B) by chemical gas phase deposition (CVD) on a substrate,
in which
a) at least one working gas is used for supplying silicon (Si) and carbon (C) and
b) at least one organic boron compound, in the molecules of which at least one carbon atom is bonded chemically to at least one boron atom, is used for supplying boron,
and in which
c) the growth temperatures on the substrate are adjusted to at least 1,000°C.

2. Process according to claim 1, in which at least one silicon compound which contains no carbon (C) is used as the working gas for supplying silicon (Si) and at least one carbon compound which contains no silicon is used as the working gas for supplying carbon (C).

3. Process according to claim 1 or claim 2, in which an excess of carbon (C) is established in the working gas, at least one of which is used.

4. Process according to one of the preceding claims, in which the partial pressure of the organic boron compound on the substrate is adjusted to between about 10⁻³ Pa and about 1 Pa.

5. Process for the preparation of monocrystalline silicon carbide doped with boron (B), in which
a) silicon carbide in solid form is at least partly sublimed,
b) the monocrystalline silicon carbide is formed from the sublimed silicon carbide in the gas phase
and
c) at least one organic boron compound, in the molecules of which at least one carbon atom is bonded chemically to at least one boron atom, is used for supplying boron.

6. Process according to claim 5, in which the monocrystalline silicon carbide is grown on a seed crystal.

7. Process according to one of the preceding claims, in which the molecules of the organic boron compound contain at least one unbranched or branched chain-like hydrocarbon radical.

8. Process according to one of the preceding claims, in which the molecules of the organic boron compound contain at least one cyclic hydrocarbon radical.

9. Process according to one of the preceding claims, in which the molecules of the organic boron compound in each case contain at least one halogen atom.

10. Process according to one of the preceding claims, in which the molecules of the organic boron compound contain at least two boron atoms, each of which is bonded chemically to at least one carbon atom.

11. Process according to one of the preceding claims, in which at least one carrier gas is passed through the organic boron compound and the carrier gas enriched with the organic boron compound is fed to the monocrystalline silicon carbide which forms.

12. Process according to claim 11, in which hydrogen is used as the carrier gas.

13. Process according to claim 11, in which at least one noble gas is used as the carrier gas.

14. Process according to claim 11, in which a gas mixture of hydrogen and at least one noble gas is used as the carrier gas.

15. Process according to one of claims 11 to 14, in which the doping agent concentration for the boron in the monocrystalline silicon carbide is adjusted by adjusting the flow rate of the carrier gas through the organic boron compound.

16. Process according to one of the preceding claims, in which the doping agent concentration for the boron in the monocrystalline silicon carbide is controlled by adjusting the temperature of the organic boron compound.

## Revendications

1. Procédé de préparation de carbure de silicium monocristallin dopé au bore (B) par dépôt chimique en phase gazeuse (CVD) sur un substrat,
dans lequel
a) on utilise au moins un gaz de travail pour amener du silicium (Si) et du carbone (C) ainsi que
b) au moins un composé organique du bore dans la molécule duquel au moins un atome de carbone est lié chimiquement à au moins un atome de bore, pour amener du bore,
et dans lequel
c) on règle les températures de croissance sur le substrat à au moins 1000°C.

2. Procédé suivant la revendication 1, dans lequel on utilise au moins un composé de silicium qui ne comporte pas de carbone (C) comme gaz de travail pour amener du silicium (Si) et au moins un composé du carbone qui ne contient pas de silicium comme gaz de travail pour amener du carbone (C).

3. Procédé suivant la revendication 1 ou la revendication 2, dans lequel on établit un excès de carbone (C) dans l'au moins un gaz de travail.

4. Procédé suivant l'une des des revendications précédentes, dans lequel on règle la pression partielle du composé organique de bore sur le substrat entre 10-3 Pa environ et 1 Pa environ.

5. Procédé de préparation de carbure de silicium monocristallin dopé au bore (B), dans lequel
a) on sublime au moins partiellement du carbure de silicium sous forme solide,
b) on forme le carbure de silicium monocristallin en phase gazeuse à partir du carbure de silicium sublimé,
c) on utilise au moins un composé organique du bore, dans la molécule duquel au moins un atome de carbone est lié chimiquement à au moins un atome de bore, pour amener du bore.

6. Procédé suivant la revendication 5, dans lequel on fait croître le carbure de silicium monocristallin sur un cristal germe.

7. Procédé suivant l'une des revendications précédentes, dans lequel les molécules du composé organique de bore comportent au moins un radical hydrocarboné à chaîne non ramifiée ou ramifiée.

8. Procédé suivant l'une des revendications précédentes, dans lequel les molécules du composé organique de bore comportent au moins un radical hydrocarboné cyclique.

9. Procédé suivant l'une des revendications précédentes, dans lequel les molécules du composé organique de bore comportent respectivement au moins un atome d'halogène.

10. Procédé suivant l'une des revendications précédentes, dans lequel les molécules du composé organique de bore comportent au moins deux atomes de bore qui sont respectivement liées chimiquement à au moins un atome de carbone.

11. Procédé suivant l'une des revendications précédentes, dans lequel on envoie au moins un gaz porteur dans le composé organique de bore et on envoie le gaz porteur enrichi en le composé organique de bore au carbure de silicium monocristallin qui se forme.

12. Procédé suivant la revendication 11, dans lequel on utilise comme gaz porteur de l'hydrogène.

13. Procédé suivant la revendication 11, dans lequel on utilise comme gaz porteur au moins un gaz rare.

14. Procédé suivant la revendication 11, dans lequel on utilise comme gaz porteur un mélange gazeux d'hydrogène et d'au moins un gaz rare.

15. Procédé suivant l'une des revendications 11 à 14, dans lequel on règle la concentration en substance dopante pour le bore dans le carbure de silicium monocristallin, en réglant le débit du gaz porteur dans le composé organique de bore.

16. Procédé suivant l'une des revendications précédentes, dans lequel on se rend maître de la concentration en substance dopante pour le bore dans le carbure de silicium monocristallin, en réglant la température du composé organique de bore.
